# EUROPEAN PATENT SPECIFICATION

(11) **EP 1 035 757 B1**
(45) Date of publication and mention of the grant of the patent: **09.04.2008**
(21) Application number: 99944818.6
(22) Date of filing: 24.09.1999
(51) Int. Cl.: H05H 1/24, H05H 1/46, H01L 21/3065, C23C 16/50, H01J 37/32

(54) **SUBSTRATE ELECTRODE PLASMA GENERATOR AND SUBSTANCE/MATERIAL PROCESSING METHOD**
PLASMAERZEUGER MIT SUBSTRATELEKTRODE UND VERFAHREN ZUR BEHANDLUNG VON STOFFEN/ MATERIALEN
GENERATEUR DE PLASMA A ELECTRODES DE SUBSTRAT ET PROCEDE DE TRAITEMENT DE SUBSTANCES/MATERIAUX

(30) Priority: 24.09.1998 JP 27034998; 25.09.1998 JP 27212598
(43) Date of publication of application: 13.09.2000
(73) Proprietor: Seiko Epson Corporation, Shinjuku-ku Tokyo 163-0811 (JP); Terashima, Kazuo, Mitaka-shi, Tokyo 181-0001 (JP)
(72) Inventor: TERASHIMA, Kazuo, Mitaka-shi, Tokyo 181-0001 (JP); SEKI, Shunichi, Suwa-shi, Nagano 392-8502 (JP); SHIMODA, Tatsuya, Suwa-shi, Nagano 392-8502 (JP); IZAKI, Takeshi, Toshima-ku, Tokyo 170-0001 (JP)
(74) Representative: Sturt, Clifford Mark
(86) International application number: PCT/JP1999/005228
(87) International publication number: WO 2000/018198

(56) References cited:
- JP-A- 8 218 176
- JP-A- 8 222 399
- JP-A- 9 213 684
- JP-A- 11 067 493
- JP-A- 11 144 892
- JP-U- 2 041 400
- US-A- 4 411 733
- US-A- 4 504 955
- PATENT ABSTRACTS OF JAPAN vol. 1997, no. 03, 31 March 1997 (1997-03-31) & JP 8 306499 A (TERAJIMA KAZUO), 22 November 1996 (1996-11-22)

## Description

### TECHNICAL FIELD

The present invention relates to a substrate electrode plasma generating apparatus and the use of such for achieving materials processing, such as thin film formation, surface processing of substrates or matter, and chemical reactions.

### BACKGROUND ART

Materials processing techniques using plasma generating apparatuses are widely used in advanced materials preparation, as currently represented by electronic devices and ULSI. However, the problems with these apparatuses include high costs, large size, high power consumption, difficult processes and inefficiency in the creation of new matter and materials. In particular, there are no means for generating plasma in arbitrarily small regions and for processing using plasma.

U.S. patent 4,504,955, issued on 12th March 1985, discloses an arc discharge device comprising a glass tube and a pyrex gas cell, which together form the orthogonal limbs of a cruciform apparatus. In the centre of this apparatus is disposed an electrically insulating substrate on which is arranged a plurality of strip electrodes with a small gap between each pair of adjacent strips. In one known arrangement a high-voltage and a low-voltage power supply are switchably connected between the first and last strips. A gas is introduced into the device such as to flow in a direction nomial to the electrically insulating substrate. The use of the high-voltage supply breaks down the gaps, which are in series with each other, and generates a plasma. Thereafter the low-voltage supply takes over for enabling continuous wave or pulsed operation in conjunction with the flow of the gas. A different arrangement is described, in which a thin-film layer is provided between the pairs of electrodes, covering the gaps. To provide the thin-film layer, a short-duration pulse from the high-voltage supply is applied to the electrodes in order to evaporate material therefrom, this material then depositing itself on the gaps as the thin film. Thereafter plasma is initiated and operation is sustained using the low-voltage supply only.

A segmented plasma excitation and recombination (SPER) device is disclosed in US 4,411,733, issued on 25th October 1983. A high-voltage supply is employed to pre-ionize the gap between a pair of electrodes disposed on a substrate in a chamber, after which a low-voltage supply is used for sustained operation in conjunction with the flow of a gas in a direction normal to the substrate. The gas flows through a hole in the substrate below the gap. The plasma thus formes in the gap is attracted to a workpiece situated in a remote part of the chamber. To facilitate this attraction, a third voltage supply applies a voltage between the workpiece and one of the electrodes.

In JP 9213684, published on 15th August 1997, an apparatus for performing etching is described, in which a container contains a substrate, on which is provided a series of electrodes. Also contained in the container is an electrode, on which is disposed a sample to be etched. In use, a bias power supply is applied to the etching electrode, while a second power supply is applied to alternate electrodes on the substrate, and a gas is introduced into the container via a series of holes. This generates a plasma, which is made to impact upon the sample, thereby etching away some of the sample.

### DISCLOSURE OF THE INVENTION

In view of such circumstances, it is an object of the present invention to provide a plasma generating apparatus that is inexpensive, small in size, has low power consumption, allows for simple processing, and makes the creation and development of new matter and materials very efficient. Furthermore it is an object of the present invention to provide methods for processing matter and materials using the plasma generating apparatus, including thin film formation, surface processing and chemical reactions in a plurality of arbitrarily small regions of a substrate.

In order to achieve these objects, a substrate electrode plasma generating apparatus in accordance with a first aspect of the present invention comprises the features set forth in claim 1.

In a second aspect of the invention the use of the invention to form thin films, to perform surface processing or to effect chemical reactions is defined in claims 7, 8, 10, 11 and 12.

Embodiments of the invention are recited in the dependent claims.

### BRIEF DESCRIPTION OF THE DRAWINGS

Figure 1 is a diagram showing the overall constitution of a substrate electrode plasma generating apparatus forming part of an embodiment of the invention;
Figure 2 is a view from above, using a scanning electron microscope, of a pair of substrate electrodes;
Figure 3 is a view using a scanning electron microscope of a substrate electrode; (A) is a view from above the substrate electrode array; and (B) is a side view of the vicinity of the plasma generation area;
Figure 4 is a diagram showing the situation of plasma generation with the substrate electrodes shown in Figure 2; (A) shows before plasma generation; (B) shows during plasma generation;
Figure 5 shows the process for forming various thin films at arbitrary locations on the same or a different substrate using a substrate electrode plasma generating apparatus according to the invention;
Figure 6 shows a substrate surface processing method using a substrate electrode plasma generating apparatus according to the invention;
Figure 7 shows a process for forming micro-optical thin films with a combination of a substrate electrode plasma generating apparatus according to the invention and an inkjet printing apparatus; and
Figure 8 shows silicon etching using a substrate electrode plasma generating apparatus according to the invention.

### BEST MODE FOR CARRYING OUT THE INVENTION

The preferred embodiments are explained below using the drawings.

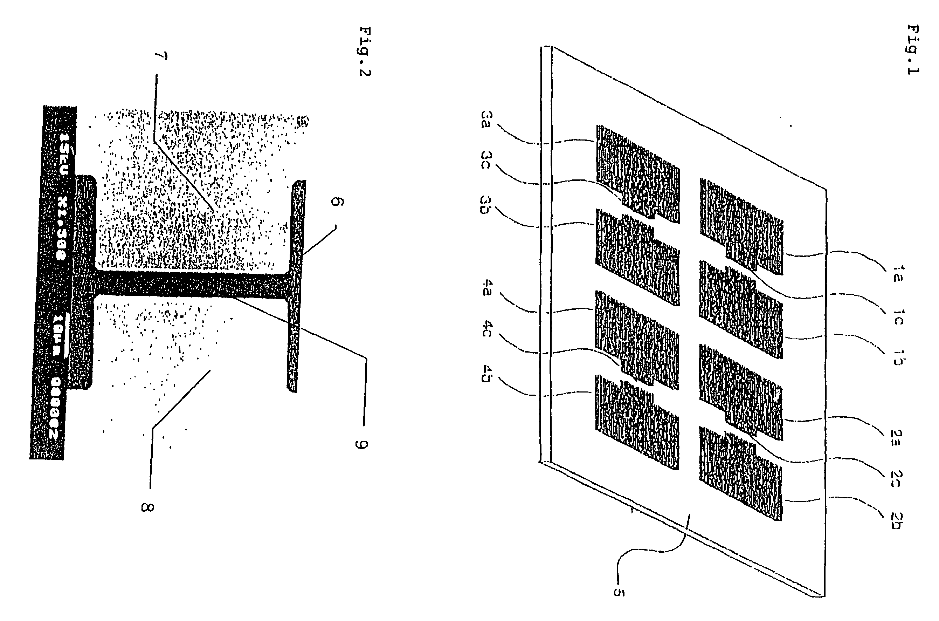

Figure 1 shows an overall view of a substrate electrode plasma generating apparatus forming part of an embodiment of the invention. Tungsten is sputtered and deposited on a silicon substrate 5 with an oxidized surface and small gap thin film electrode pairs 1-4 are formed with dry etching. A plasma array apparatus, comprising four pairs of plasma generating electrodes in a two by two arrangement, is shown here, but an arrangement of any number at any location, according to the desired plasma processing, is acceptable. Each of electrode is wired together in a matrix form so that plasma can be generated between any pair of electrodes. Also, plasma generation may be controlled by the application of voltage between any pair of electrodes by active elements such as transistors.

Figure 2 is a micrograph of a pair of substrate electrodes taken with a scanning electrod microscope. Tungsten electrodes 7 and 8 are formed with a 5µm gap 9 between the electrodes. The size of the substrate electrodes may be on the order of µm to cm.

**Table 1**

| | | | | | | | | | | | |
|---|---|---|---|---|---|---|---|---|---|---|---|
| Pressure | (kPa) | 50.6 | 101.3 | 152.0 | 202.6 | 253.2 | 304.0 | 354.6 | 405.2 | 455.8 | 506.5 |
| | ((atm)) | (0.5) | (1.0) | (1.5) | (2.0) | (2.5) | (3.0) | (3.5) | (4.0) | (4.5) | (5.0) |
| Breakdown voltage (V) | | 330 | 340 | 310 | 280 | 270 | 280 | 280 | 290 | 300 | 320 |

Table 1 shows the relationship between pressure and breakdown voltage in an argon atmosphere.

Also, plasma generation in air or hydrogen at 101.325kPa (1 atm) was observed at an applied voltage of 400 V with both tungsten and platinum electrodes having gaps of 5µm to 10µm therebetween.

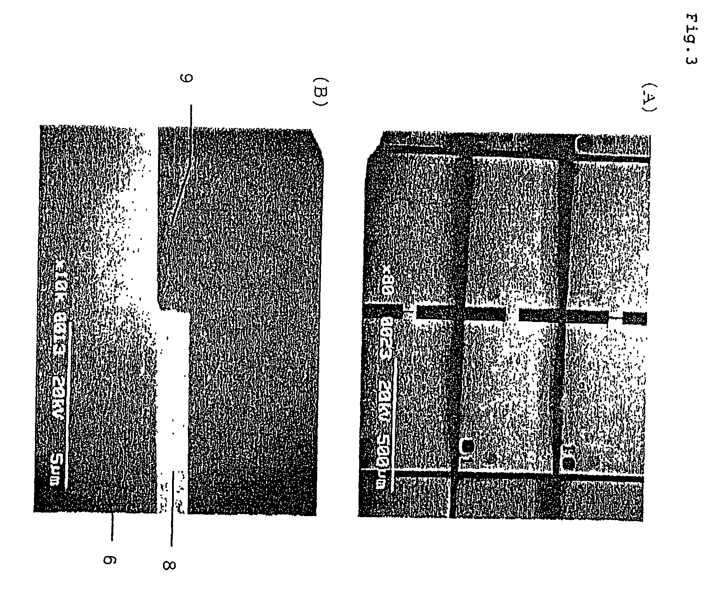

Figure 3 (A) shows a micrograph from above the substrate electrode array. Figure 3 (B) shows a micrograph of the vicinity of the plasma generation area 9 seen from the side.

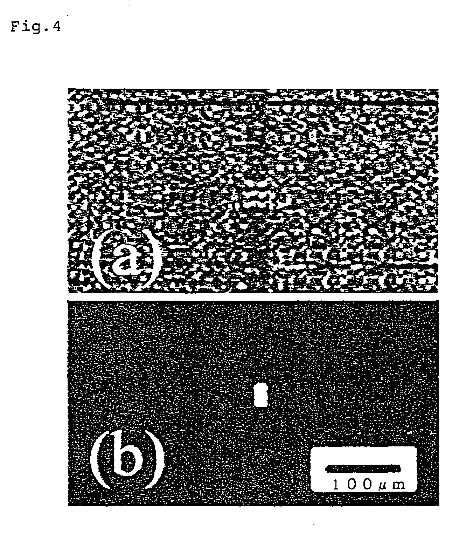

Figure 4 is a diagram showing the situation of plasma generation with the substrate electrodes; (A) shows before plasma generation; (B) shows during plasma generation.

Before now, there were no examples of plasma being generated in micro-regions using electrodes on a substrate; this first became possible with the present invention. The substrate electrode plasma generating apparatus makes possible micro-fine plasma generation at a plurality of arbitrary locations on a single substrate surface.

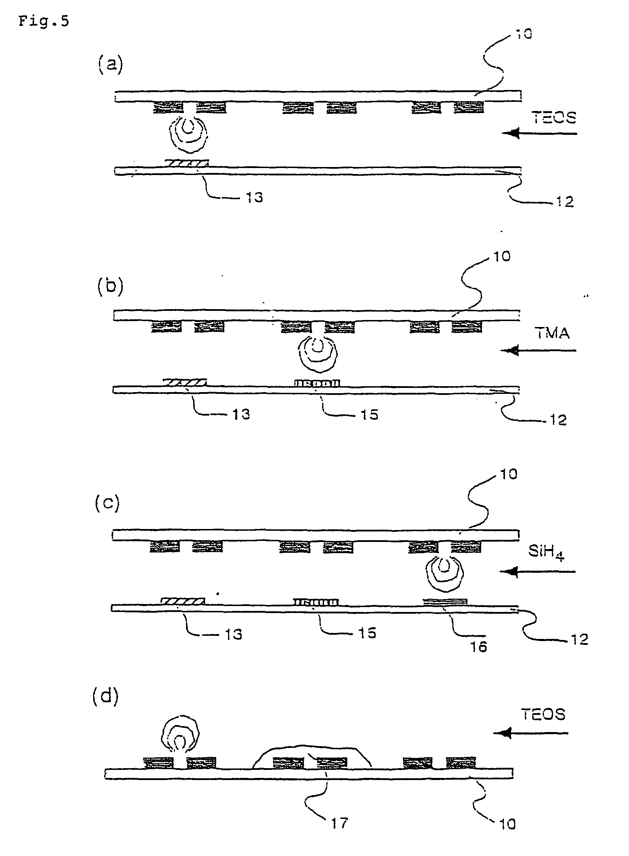

Figure 5 is a diagram showing the process for forming various thin films at arbitrary locations on the same or separate substrates using a substrate electrode plasma generating apparatus in accordance with the invention. As shown in Figure 5(a), the silicon substrate 12 is positioned opposite to the substrate electrode plasma generating apparatus 10; an SiO₂ thin film (13) can be formed at any desired position by generating plasma at that position while triethoxysilane (TEOS) gas is introduced into an air or oxygen gas atmosphere. In Figure 5(b), an aluminum thin film (15) is formed when plasma is generated at another electrode pair while trimethoxyaluminum (TMA) is introduced into vacuum. Next, Figure 5(c) shows the formation of a silicon thin film (16) at a separate location as monosilane (SiH₄) is introduced into vacuum. In this way, it becomes possible to use the substrate electrode plasma generating apparatus to form and pattern thin films comprising arbitrary materials at arbitrary locations by varying the reaction gas. Furthermore, it becomes possible to form various elements such as TFT's at arbitrary positions by introducing apparatuses for laser abrasion and ion doping.

Figure 5(d) shows the formation of an SiO₂ insulating film on the same substrate as the substrate electrode plasma generating apparatus with the introduction of triethoxysilane (TEOS). Controlling the type of reaction gas and the plasma generation region makes it possible to form thin films, semiconductor films, and so forth on the same substrate at any location.

Also, it is possible to form acrylic on the substrate by plasma polymerization through generating plasma while a reaction material that is not gas, but rather a liquid such as acrylic monomer, is introduced. Micro-optical elements with differing refractive indexes can also be formed on the same substrate by controlling the type of monomer and plasma conditions.

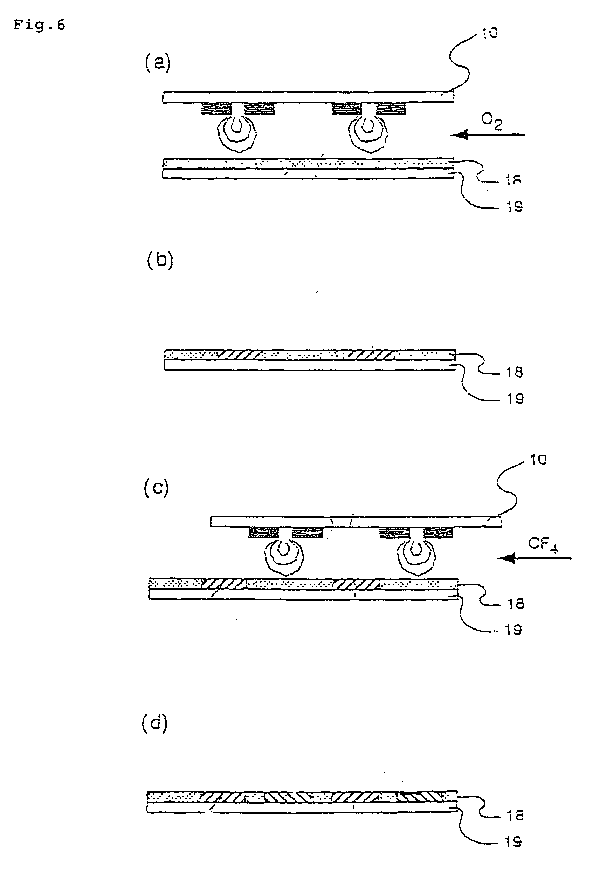

Figure 6 shows the process for surface processing of a substrate using a substrate electrode plasma generating apparatus in accordance with the invention. A substrate comprising a polyimide film 18 formed on a glass substrate 19 undergoes plasma processing in an oxygen atmosphere. This may be done in air or as oxygen gas is introduced. As shown in Figure 6 (b), arbitrary locations of the surface may be made hydrophilic. This oxygen plasma processing also has ashing effects on the polyimide residue. Next, a hydrophobic surface can be formed by shifting the substrate or the substrate electrode plasma generating apparatus and performing plasma processing for the unprocessed polyimide surface while CF₄ gas is introduced. The reaction gas may also be another fluorine gas such as SiF₄. Accordingly, it becomes possible to reform any location of the surface on the same substrate to have hydrophilic or hydrophobic properties, as shown in Figure 6(d).

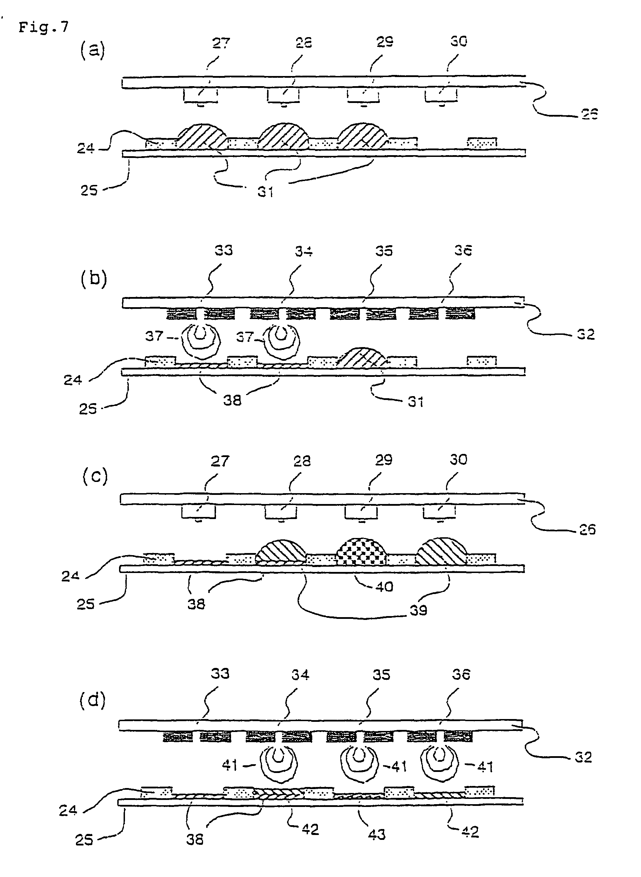

Figure 7 shows a process for forming micro-optical thin films with a combination of the substrate electrode plasma generating apparatus in accordance with the invention and an inkjet printing apparatus. From an inkjet printing apparatus 26, having inkjet heads 27, 28, 29, 30, SiO₂ precursor ink 31 is sprayed and patterned from inkjet heads 27, 28 and 29 onto a desired glass surface on a glass substrate 25 having partitions 24 formed of polyimide. For example, liquid including polysilazane is preferred as the SiO₂ precursor ink. Plasma 37 is generated with substrate electrode pairs 33 and 34 and an SiO₂ thin film 38 is formed using the substrate electrode plasma generating apparatus 32 comprising substrate electrode pairs 33, 34, 35 and 36. Furthermore, as shown in Figure 7 (c), TiO₂ precursor ink 39 is sprayed from inkjet heads 28, 28 and 30. A liquid including a metal alkoxide such as titanium tetraisopropoxide is used as the TiO₂ precursor ink. Finally, plasma 41 is generated with substrate electrode pairs 34, 35 and 36 and a TiO₂ film 42 and (Si, Ti)O₂ mixed film 43 are formed. Consequently, combining the substrate electrode plasma generating apparatus and inkjet printing apparatus as shown in Figure 7(d) makes it possible and simple to form four types of thin films, TiO₂, SiO₂, SiO₂/TiO₂ layered film, and (Si, Ti)O₂ mixed film, on a single substrate. Optical thin films with different refractive indexes can be formed on the same substrate through the formation of thin films comprising materials with different refractive indexes such as TiO₂, SiO₂, and (Si, Ti)O₂. The formation of a DBR mirror is also made possible by layering thin films with different refractive indexes.

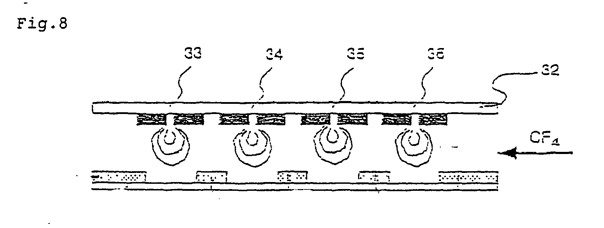

Figure 8 shows local etching of a silicon substrate using the substrate electrode plasma generating apparatus in accordance with the invention. Etching of silicon at any position is possible. A fluorine gas such as CF₄ is effective as the atmospheric gas.

### INDUSTRIAL APLICABILITY

As discussed above, the substrate electrode plasma generating apparatus relating to the present invention is smaller, more inexpensive and consumes less power than a conventional plasma apparatus, and furthermore, makes possible simple and highly efficient matter and materials processing methods such as the formation of functional thin films at a plurality of tiny regions anywhere on a substrate, surface processing and chemical reactions. Combining the plasma generating apparatus with an inkjet printing apparatus makes possible simple functional thin film formation and matter and materials processing for a wide range of the above-mentioned functional thin films and matter and materials.

## Claims

1. A substrate electrode plasma generating apparatus, comprising:
a first substrate (5; 10), upon which is disposed an electrode pair (1; 2; 3; 4) including first and second electrodes (1a, 1b; 2a, 2b; 3a, 3b; 4a, 4b) positioned adjacent to each other with a gap (9) therebetween;
a plasma generating means including a power supply connected to the first and second electrodes for generating a plasma between the first and second electrodes, and
a second substrate (12) disposed opposite the first substrate and facing the electrode pair;
**characterized in that**:
the electrode gap (9) is 5 µm to 10 µm in width.

2. The apparatus according to claim 1, wherein the plasma is direct-current plasma, alternating-current plasma or a high-frequency plasma.

3. The apparatus according to claim 1, wherein the plasma generating means is arranged to generate the plasma in an arbitrary atmosphere.

4. The apparatus according to claim 3, wherein the arbitrary atmosphere is a vacuum, a gas or a liquid.

5. The apparatus according to claim 1, wherein the electrode pair comprises thin films established on a substrate.

6. The apparatus according to claim 1, wherein a plurality of electrode pairs (1-4) is established on the first substrate, the apparatus being configured such as to control each of the electrode pairs independently.

7. The use of the substrate electrode plasma generating apparatus defined in any one of claims 1 to 6 to form thin films (38) comprising arbitrary materials at arbitrary positions on said second substrate (12) or on a separate material.

8. The use of the substrate electrode plasma generating apparatus defined in any one of claims 1to 6 to form thin films comprising arbitrary materials at arbitrary positions on said first substrate (10).

9. The use of the substrate electrode plasma generating apparatus, as claimed in claim 7 or claim 8, wherein the source material of said thin films is a gas or a liquid.

10. The use of the substrate electrode plasma generating apparatus defined in any one of claims 1 to 6 to perform at least one type of surface processing selected from among: ashing, etching, washing and reforming of a surface of said second substrate (19; 46).

11. The use of the substrate electrode plasma generating apparatus defined in any one of claims 1 to 6 to effect chemical reactions using an arbitrary material at arbitrary positions on said second substrate (19).

12. The use of the substrate electrode plasma generating apparatus defined in any one of claims 1 to 6 to effect chemical reactions using an arbitrary material at arbitrary positions on said first substrate.

13. The use of the substrate electrode plasma generating apparatus, as claimed in any one of claims 7 to 9, wherein, for the formation of the thin films, an arbitrary liquid material is supplied by means of an inkjet method.

14. The use of the substrate electrode plasma generating apparatus, as claimed in claim 13, wherein a plurality of nozzles is used to supply one or more types of liquid material in said inkjet method.

## Patentansprüche

1. Plasmaerzeugungsgerät mit Substratelektrode, umfassend:
ein erstes Substrat (5; 10), auf dem ein Elektrodenpaar (1; 2; 3; 4) angeordnet ist, mit ersten und zweiten Elektroden (la, 1b; 2a, 2b; 3a, 3b; 4a, 4b), die mit einem dazwischen liegenden Spalt (9) nebeneinanderangeordnet sind;
ein Plasmaerzeugungsmittel, das eine Energieversorgung enthält, die an die ersten und zweiten Elektroden angeschlossen ist, um ein Plasma zwischen den ersten und zweiten Elektroden zu erzeugen, und
ein zweites Substrat (12), das gegenüber dem ersten Substrat angeordnet und dem Elektrodenpaar zugewandt ist;
**dadurch gekennzeichnet, dass**:
der Elektrodenspalt (9) 5 µm bis 10 µm breit ist.

2. Gerät nach Anspruch 1, wobei das Plasma Gleichstromplasma, Wechselstromplasma oder Hochfrequenzplasma ist.

3. Gerät nach Anspruch 1, wobei das Plasmaerzeugungsmittel zum Erzeugen des Plasmas in einer beliebigen Atmosphäre angeordnet ist.

4. Gerät nach Anspruch 3, wobei die beliebige Atmosphäre ein Vakuum, ein Gas oder eine Flüssigkeit ist.

5. Gerät nach Anspruch 1, wobei das Elektrodenpaar Dünnfilme umfasst, die auf einem Substrat gebildet sind.

6. Gerät nach Anspruch 1, wobei mehrere Elektrodenpaare (1 bis 4) auf dem ersten Substrat gebildet sind und das Gerät so konfiguriert ist, dass jedes der Elektrodenpaare unabhängig gesteuert wird.

7. Verwendung des Plasmaerzeugungsgeräts mit Substratelektrode, wie in einem der Ansprüche 1 .bis 6 definiert, zur Bildung von Dünnfilmen (38), die beliebige Materialien umfassen, an beliebigen Positionen auf dem zweiten Substrat (12) oder auf einem separaten Material.

8. Verwendung des Plasmaerzeugungsgeräts mit Substratelektrode, wie in einem der Ansprüche 1 bis 6 definiert, zur Bildung von Dünnfilmen (38), die beliebige Materialien umfassen, an beliebigen Positionen auf dem ersten Substrat (10).

9. Verwendung des Plasmaerzeugungsgeräts mit Substratelektrode nach Anspruch 7 oder Anspruch 8, wobei das Quellenmaterial der Dünnfilme ein Gas oder eine Flüssigkeit ist.

10. Verwendung des Plasmaerzeugungsgeräts mit Substratelektrode, wie in einem der Ansprüche 1 bis 6 definiert, zur Durchführung mindestens einer Art von Oberflächenbearbeitung, ausgewählt aus: Aschen, Ätzen, Waschen und Umformen einer Oberfläche des zweiten Substrats (19; 46).

11. Verwendung des Plasmaerzeugungsgeräts mit Substratelektrode, wie in einem der Ansprüche 1 bis 6 definiert, zur Ausführung chemischer Reaktionen unter Verwendung eines beliebigen Materials an beliebigen Positionen auf dem zweiten Substrat (19).

12. Verwendung des Plasmaerzeugungsgeräts mit Substratelektrode, wie in einem der Ansprüche 1 bis 6 definiert, zur Ausführung chemischer Reaktionen unter Verwendung eines beliebigen Materials an beliebigen Positionen auf dem ersten Substrat.

13. Verwendung des Plasmaerzeugungsgeräts mit Substratelektrode nach einem der Ansprüche 7 bis 9, wobei zur Bildung der Dünnfilme ein beliebiges flüssiges Material mit Hilfe einer Tintenstrahlmethode zugeführt wird.

14. Verwendung des Plasmaerzeugungsgeräts mit Substratelektrode nach Anspruch 13, wobei mehrere Düsen zum Zuleiten einer oder mehrerer Arten von flüssigem Material in dem Tintenstrahlverfahren verwendet werden.

## Revendications

1. Dispositif de génération de plasma à électrodes de substrat, comprenant :
un premier substrat (5, 10) sur lequel une paire d'électrodes (1, 2, 3, 4) est disposée incluant des premières et deuxièmes électrodes (la, 1b ; 2a, 2b ;
3a, 3b ; 4a, 4b) disposées de manière adjacente les unes des autres avec un écartement (9) entre elles ;
un moyen de génération de plasma incluant un dispositif d'alimentation connecté aux premières et deuxièmes électrodes pour générer du plasma entre les premières et deuxièmes électrodes, et
un deuxième substrat (12) disposé de manière opposée au premier substrat et faisant face à la paire d'électrodes ;
**caractérisé en ce que** :
l'écartement (9) entre les électrodes est de 5 µm à 10 µm en largeur.

2. Dispositif selon la revendication 1, le plasma étant du plasma à courant continu, du plasma à courant alternatif ou du plasma induit par haute fréquence.

3. Dispositif selon la revendication 1, le moyen de génération de plasma étant étudié pour générer le plasma dans une atmosphère arbitraire.

4. Dispositif selon la revendication 3, l'atmosphère arbitraire étant un vide, un gaz ou un liquide.

5. Dispositif selon la revendication 1, la paire d'électrodes comprenant des pellicules minces établies sur un substrat.

6. Dispositif selon la revendication 1, une pluralité de paires d'électrodes (1-4) étant disposées sur le premier substrat, le dispositif étant configuré de manière à contrôler indépendamment chacune des paires d'électrodes.

7. Utilisation du dispositif de génération de plasma à électrodes de substrat définit dans l'une quelconque des revendications 1 à 6 afin de former des pellicules minces (38) comprenant des matières arbitraires dans des positions arbitraires sur ledit deuxième substrat (12) ou sur une matière distincte.

8. Utilisation du dispositif de génération de plasma à électrodes de substrat définit dans l'une quelconque des revendications 1 à 6 afin de former des pellicules minces comprenant des matières arbitraires dans des positions arbitraires sur ledit premier substrat (10).

9. Utilisation du dispositif de génération de plasma à électrodes de substrat tel que revendiqué dans la revendication 7 ou la revendication 8, la matière d'origine desdites pellicules mince étant un gaz ou un liquide.

10. Utilisation du dispositif de génération de plasma à électrodes de substrat définit dans l'une quelconque des revendications 1 à 6 afin de réaliser au moins un type de traitement de surface sélectionné parmi : un polissage au disque toile, une gravure, un lavage et une reformation d'une surface dudit deuxième substrat (19, 46).

11. Utilisation du dispositif de génération de plasma à électrodes de substrat définit dans l'une quelconque des revendications 1 à 6 pour provoquer des réactions chimiques en utilisant une matière arbitraire dans des positions arbitraires sur ledit deuxième substrat (19).

12. Utilisation du dispositif de génération de plasma à électrodes de substrat définit dans l'une quelconque des revendications 1 à 6 pour produire des réactions chimiques en utilisant une matière arbitraire dans des positions arbitraires sur ledit premier substrat.

13. Utilisation du dispositif de génération de plasma à électrodes de substrat définit dans l'une quelconque des revendications 7 à 9, avec laquelle, pour la formation des pellicules minces, une matière liquide arbitraire est fournie à l'aide d'un procédé de jet d'encre.

14. Utilisation du dispositif de génération de plasma à électrodes de substrat tel que revendiqué dans la revendication 13, une pluralité de buses étant utilisée pour fournir un ou plusieurs types de matières liquides dans ledit procédé de jet d'encre.
